# EUROPÄISCHE PATENTSCHRIFT

(11) **EP 1 444 781 B1**
(45) Veröffentlichungstag und Bekanntmachung des Hinweises auf die Patenterteilung: **03.08.2011**
(21) Anmeldenummer: 02776841.5
(22) Anmeldetag: 18.10.2002
(51) Int. Cl.: H03K 17/16, H03K 19/003

(54) **VERFAHREN ZUR VERMEIDUNG VON TRANSIENTEN BEI SCHALTVORGÄNGEN IN INTEGRIERTEN SCHALTKREISEN SOWIE INTEGRIERTER SCHALTKREIS**
METHOD FOR PREVENTING TRANSIENTS DURING SWITCHING PROCESSES IN INTEGRATED SWITCHING CIRCUITS, AND AN INTEGRATED SWITCHING CIRCUIT
PROCEDE PERMETTANT D'EVITER L'APPARITION DE TRANSITOIRES LORS DE PROCESSUS DE COMMUTATION DANS DES CIRCUITS DE COMMUTATION INTEGRES, ET CIRCUITS DE COMMUTATION INTEGRES

(30) Priorität: 12.11.2001 DE 10155428
(43) Veröffentlichungstag der Anmeldung: 11.08.2004
(73) Patentinhaber: Infineon Technologies AG, 85579 Neubiberg (DE)
(72) Erfinder: BOETZEL, Ulrich, 41564 Kaarst (DE); NEUBAUER, Andre, 47807 Krefeld (DE); KRANZ, Christian, 40885 Ratingen Lintorf (DE); POTT, Rüdiger, 46535 Dinslaken (DE); HAMMES, Markus, 46539 Dinslaken (DE); SCHMANDT, Bernd, 42329 Wuppertal (DE); WARMERS, Michael, 41812 Erkelenz (DE); GERSEMSKY, Frank, 44789 Bochum (DE)
(74) Vertreter: Lange, Thomas
(86) Internationale Anmeldenummer: PCT/DE2002/003943
(87) Internationale Veröffentlichungsnummer: WO 2003/043192

(56) Entgegenhaltungen:
- EP-A- 0 485 918
- WO-A-95/24076
- DE-C- 19 680 526
- US-A- 4 752 703
- US-A- 5 646 572
- US-A- 5 646 572
- US-A- 5 724 297
- US-A- 5 815 694
- US-A- 6 127 839
- US-B1- 6 243 656

## Beschreibung

Verfahren zur Vermeidung von Transienten bei Schaltvorgängen in integrierten Schaltkreisen sowie integrierter Schaltkreis

Die Erfindung betrifft ein Verfahren zur Vermeidung von Transienten bei Schaltvorgängen in integrierten Schaltkreisen sowie einen integrierten Schaltkreis, bei welchem Maßnahmen zur Vermeidung von Transienten getroffen sind.

Auf Grund von Schaltvorgängen treten in integrierten Schaltkreisen (IC) mehr oder weniger große Lastschwankungen auf. Beispielsweise werden Lastschwankungen durch die zeitweise Aktivierung oder Deaktivierung von Teilbereichen bzw. Modulen eines IC bewirkt. Derartige zu- oder abschaltbare Module kommen in modernen IC mehr und mehr zum Einsatz, da durch sie eine bedarfsorientierte Steuerung der Leistungsaufnahme des IC ermöglicht wird. Nur wenn ein Modul gerade gebraucht wird, erfolgt dessen Aktivierung. Die übrige Zeit befindet sich das Modul in einem Betriebszustand mit niedriger oder ohne Leistungsaufnahme. Der Wechsel zwischen Betriebszuständen wird üblicherweise durch das Abschalten der Versorgungsspannung oder durch das Abschalten oder Reduzieren der Taktfrequenz des Moduls vorgenommen.

Nachteilig dabei ist, dass durch die Schaltvorgänge unerwünschte Transienten auf den Versorgungsleitungen erzeugt werden, welche sich störend auf andere Chipkomponenten auswirken können. Je höher die Anzahl der schaltbaren Module, desto größere Schwierigkeiten sind zu erwarten. Besonders anfällig gegenüber dem Auftreten von Transienten sind sogenannte "Mixed Signal" Systeme, welche digitale und analoge Baugruppen auf einem IC vereinen.

Zur Reduzierung des schädlichen Einflusses von Transienten ist es bereits bekannt, empfindliche Komponenten des Chips durch ein geeignete Schirmung vor den Transienten zu schützen.

Die Schrift US 5,646,572 beschreibt ein Verfahren und eine Schaltung zur Vermeidung von Transienten, indem bei Abschalten eines funktionalen. Blocks eine Dummy-Last mit vorgegebener Lasthöhe zur Beibehaltung einer konstanten Stromstärke hinzugeschaltet wird.

Der Erfindung liegt die Aufgabe zugrunde, ein Verfahren anzugeben, mit welchem der schädliche Einfluss von Transienten in integrierten Schaltkreisen vermindert werden kann. Ferner zielt die Erfindung darauf ab, einen integrierten Schaltkreis mit einer geringen Anfälligkeit gegenüber durch Transienten verursachten Störungen zu schaffen.

Die Aufgabenstellung wird durch die Merkmale der unabhängigen Ansprüche 1 und 4 gelöst. Vorteilhafte Weiterbildungen und Ausgestaltungen der Erfindung sind Gegenstand der abhängigen Ansprüche.

Erfindungsgemäß wird die beim Schalten des Moduls von dem ersten Betriebszustand in den zweiten Betriebszustand auftretende Laständerung durch gleichzeitiges Hinzu- oder Abschalten einer Dummy-Last im wesentlichen kompensiert. Da das Hinzu- oder Abschalten der Dummy-Last zeitgleich mit dem Schalten des

Moduls erfolgt, kann der Schaltvorgang als solcher abrupt sein. Das Auftreten von Transienten wird hier dadurch verhindert, dass die beim Schaltvorgang auftretende Gesamtlaständerung klein bleibt.

Es wird vor und nach dem Hinzu- oder Abschalten der Dummy-Last die Höhe der Dummy-Last gesteuert. Das Steuern der Höhe der Dummy-Last vor dem Schalten ermöglicht es, eine Dummy-Last für Schaltvorgänge von verschiedenen Modulen zu verwenden. Das Steuern der Höhe der Dummy-Last nach dem Zuschalten derselben ermöglicht die Reduzierung der Gesamtlast, was nun wieder "langsam", d.h. unter Beachtung der unteren zeitgrenze für Umschaltvorgänge, zu erfolgen hat, da ansonsten beim Abschalten der Dummy-Last der Transient auftreten würden.

Die Betriebsgröße ist die Taktfrequenz des Moduls.

Bei den beiden betrachteten Betriebszuständen handelt es sich vorzugsweise um den eingeschalteten Zustand und den ausgeschalteten Zustand des Moduls. 'Eine andere Möglichkeit-besteht darin, dass einer der beiden Betriebszustände-ein Zustand mit reduzierter Taktfrequenz ist. Dies kann z.B. ein Bereitschaftszustand oder, bei reduzierter Taktfrequenz, ein Zustand mit reduzierter Rechenkapazität und Leistungsaufnahme sein.

Schaltvorgänge einzelner Module in Zustände mit reduzierter Leistungsaufnahme sind insbesondere bei Chips im Mobilfunkbereich von Interesse. Da in Mobilfunkempfängern die Leistungsaufnahme der ICs strikten Begrenzungen unterliegt, ist es hier besonders interessant, einzelne Module "niedrig" zu takten, wenn von ihnen in bestimmten Situationen nur eine mittlere oder geringe Rechenleistung benötigt wird. Infolge dessen ermöglicht die Erfindung, bei einem Power-Management von Modulen in einem Chip die durch Transienten bewirkten Störeinflüsse deutlich zu vermindern.

Ein erfindungsgemäßer IC ist in Auspruch 4 angegeben.

Vorzugsweise umfasst der IC sowohl analoge als auch digitale Module. Dabei kann es sich auch bei dem betrachteten schaltbaren Modul sowohl um ein analoges als auch ein digitales Modul handeln.

Die Erfindung wird nachfolgend anhand eines Ausführungsbeispiel unter Bezugnahme auf die Zeichnung erläutert; in dieser zeigt:
- Fig. 1: ein vereinfachtes Blockschaltbild zur Erläuterung des Aufbaus eines ersten Ausführungsbeispiels eines erfin- dungsgemäßen IC; und
- Fig. 2: ein vereinfachtes Blockschaltbild eines nicht zur Erfindung gehörenden Schaltungsaufbaus zur Erläuterung des Schaltens einer Dummy-Last.

Moderne ICs umfassen eine Vielzahl von Komponenten bzw. Modulen unterschiedlicher Komplexität und unterschiedlichen Aufbaus. Dabei werden zur Erzielung einer höheren Systemintegration auch analoge und digitale Module auf ein und demselben IC realisiert. Beispielsweise kann ein IC ein oder mehrere A/D-Umsetzer, D/A-Umsetzer, Logikeinheiten, Speicherbereiche sowie einen Mikroprozessor oder einen Mikro-Controller als unterschiedliche Module umfassen. Im Bereich von Mobilfunkanwendungen werden analoge Hochfrequenzbauteile (z.B. Mischstufen) zusammen mit digitalen Basisband-Baugruppen (z.B. digitalen Filtern) auf einem IC realisiert. Ein weiteres Beispiel für IC-integrierte Module sind aufgabenspezifische Hardware-Datenpfade, die bestimmte vorgegebene Rechenaufgaben in sequentieller Logik ausführen.

Ein Modul im Sinne der Erfindung ist somit eine im wesentlichen eigenständige Funktionseinheit oder Baugruppe auf einem IC, die mit anderen Komponenten oder weiteren schaltbaren Modulen des IC zusammenarbeitet, wobei das Modul in der Regel an bestimmten gemeinsamen Resourcen wie beispielsweise der Leistungsversorgung oder Taktgenerierung des IC partizipiert.

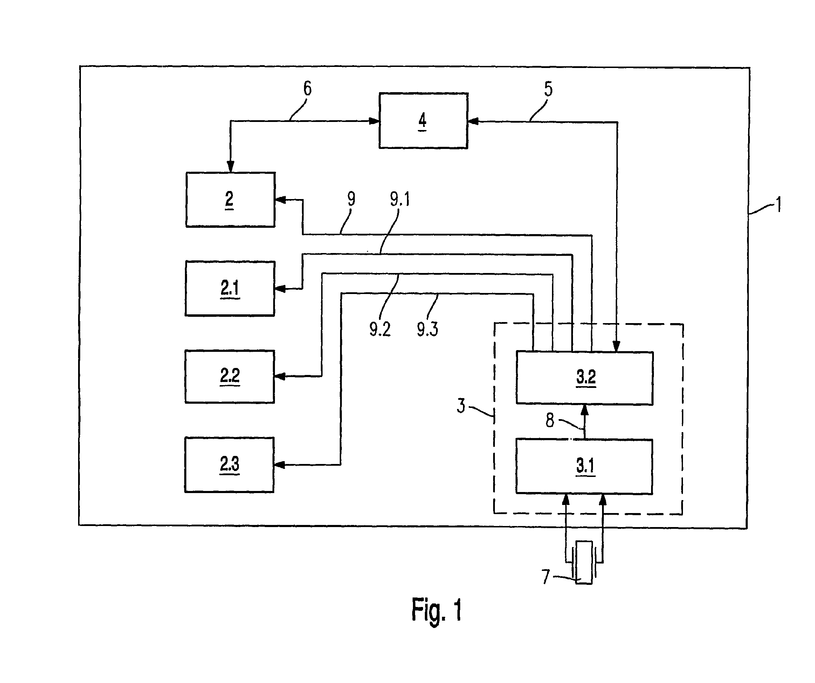

Figur 1 zeigt in vereinfachter Darstellung den Aufbau eines solchen IC 1 in Form eines Blockschaltbildes. Der IC 1 umfasst eine zentrale Verarbeitungseinheit (CPU) 2 und mehrere weitere Module 2.1, 2.2 und 2.3. Die Module 2.1 bis 2.3 übernehmen verschiedene, aufgabenspezifische Funktionen des IC 1 und können beispielsweise in Form der oben genannten Funktionseinheiten realisiert sein.

Der IC 1 umfasst ferner eine Takterzeugungsschaltung 3, welche in dem hier dargestellten Beispiel aus einem Taktgenerator 3.1 und einem Taktteiler 3.2 aufbaut ist. Der Taktgenerator 3.1 wird durch einen externen Schwingquarz 7 betrieben. Er erzeugt eine feste Taktfrequenz, die über eine Leitung 8 dem Taktteiler 3.2 zugeführt wird.

Eine Steuerschaltung 4 steht über bidirektionale Datenverbindungen 5 und 6 sowohl mit dem Taktteiler 3.2 als auch mit der zentralen Verarbeitungseinheit 2 in Verbindung.

Der Taktteiler 3.2 erzeugt die Taktsignale für die zentrale Verarbeitungseinheit 2 und die diversen Module 2.1, 2.2 und 2.3. Die Taktleitungen, über welche die Taktsignale zu den genannten Einheiten bzw. Modulen geführt werden, sind in Figur 1 mit den Bezugszeichen 9 (für die CPU 2), 9.1 (für das Modul 2.1), 9.2 (für das Modul 2.2) und 9.3 (für das Modul 2.3) bezeichnet.

Die Funktionsweise der in Figur 1 dargestellten Schaltung ist wie folgt:
Beispielsweise soll das Modul 2.2 aufgrund geringer Auslastung in einen Betriebszustand mit niedriger Leistungsaufnahme geschaltet werden. Die Möglichkeit, das Modul 2.2 niedriger zu takten, wird in der zentralen Verarbeitungseinheit 2 erkannt und eine entsprechende Information wird über die Datenverbindung 6 an die Steuerschaltung 4 gesendet. Der Steuerschaltung 4, die gleichzeitig eine Zustandsüberwachungseinrichtung sein kann, können die Betriebszustände und Taktfrequenzen der zentralen Verarbeitungseinheit 2 und sämtlicher Module 2.1, 2.2 und 2.3 bekannt sein bzw. werden ihr über die Datenverbindungen 6 bzw. 5 übermittelt. Unter optionaler Berücksichtigung solcher Systeminformationen weist die Steuerschaltung 4 den programmierbaren Frequenzteiler 3.2 an, die Taktfrequenz für das Modul 2.2 auf einen gewünschten Zielwert zu reduzieren. Dieser Zielwert wird von der zentralen Verarbeitungseinheit 2 variabel bestimmt.

Ein Spezialfall besteht darin, dass das Modul 2.2 abgeschaltet werden soll. In diesem Fall beträgt der Zielwert 0 Hz.

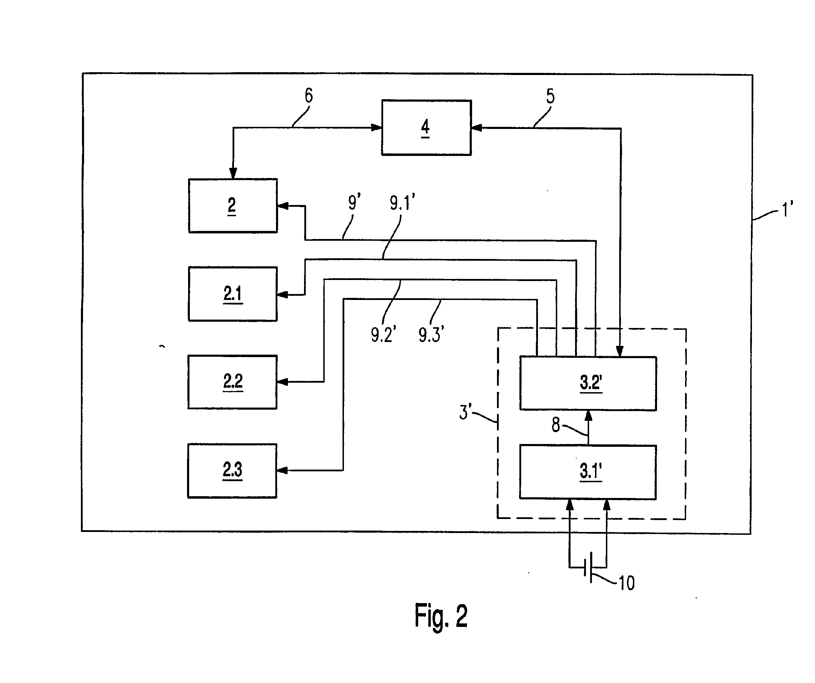

. Blockschaltbild eines weiteren Schaltungsaufbaus Figur 2 zeigt in schematischer Weise ein Blockschaltbild eines weiteren Schaltungsaufbaus . Die selben oder funktional vergleichbare Teile sind mit den selben Bezugszeichen wie in Figur 1 gekennzeichnet. Der wesentliche Unterschied zwischen dem in Figur 1 dargestellten Ausführungsbeispiel und dem in Figur 2 dargestellten Schaltungsaufbau besteht darin, dass in Figur 2 der Übergang eines Moduls 2.1, 2.2 bzw. 2.3 von einem ersten Betriebszustand in einen zweiten Betriebszustand durch eine Änderung der Versorgungsspannung des entsprechenden Moduls bewirkt wird. Insofern ist mit dem Bezugszeichen 3.1' eine Schaltung zur Erzeugung einer Versorgungsspannung und mit dem Bezugszeichen 3.2' eine Schaltung zur Steuerung und Veränderung der von der Schaltung 3.1' über die Leitung 8 erhaltenen Versorgungsspannung bezeichnet. Mit dem Bezugszeichen 10 wird eine externe Leistungsquelle, beispielsweise eine Batterie, bezeichnet und das Bezugszeichen 3' bezeichnet eine Schaltung zur Erzeugung der Versorgungsspannungen für die zentrale Verarbeitungseinheit 2 und die Module 2.1, 2.2 und 2.3. Die Versorgungsspannungsleitungen, über welche die Versorgungsspannungen zu den genannten Modulen geführt werden, sind in Figur 2 mit den Bezugszeichen 9' (für die CPU 2), 9.1' (für das Modul 2.1), 9.2' (für das Modul 2.2) und 9.3' (für das Modul 2.3) bezeichnet.

Die Funktionsweise der Komponenten des IC 1' ist analog zu der Funktionsweise der Komponenten des IC 1. Die Analogie besteht darin, dass statt Taktfrequenzen bzw. Taktfrequenzänderungen nun Betriebsspannungen bzw. Betriebsspannungsänderungen und damit verbundene Schaltvorgänge betrachtet werden. Zur Vermeidung von Wiederholungen wird im Sinne dieser Analogie auf die Beschreibung zum ersten Ausführungsbeispiel verwiesen.

Das Ausführungsbeispiel der Erfindung wird an dem Schaltungsaufbau der Fig. 2 erläutert. Das zu schaltende Modul 2.2 wird durch eine Dummy-Last ergänzt, welche hier mit dem Bezugszeichen 2.3 dargestellt sein soll. Der Schaltvorgang bezüglich des Moduls 2.2 kann abrupt durchgeführt werden. Gleichzeit wird die Dummy-Last 2.3 ebenfalls abrupt hinzugeschaltet. Die Dummy-Last 2.3 ist so bemessen, dass sie die durch das Schalten des Moduls 2.2 bewirkte Laständerung gerade kompensiert. Da infolgedessen keine oder nur eine sehr geringe Gesamtlaständerung mit dem Schaltvorgang verbunden ist, wird das Auftreten von Transienten wirkungsvoll unterdrückt.

Die Dummy-Last 2.3 ist von einstellbarer Größe, wodurch zweierlei erreicht wird: Erstens kann sie bei Schaltvorgängen für verschiedene Laständerungen oder Module eingesetzt werden. Zweitens kann sie nach einem Hinzuschalten langsam gedrosselt werden, wodurch die Gesamtlast - und damit der Stromverbrauch - in gewünschter Weise wieder reduziert wird.

Fesner Kann das zu schaltende Modul konstruktiv in mehrere Untermodule gegliedert, welche einzeln schaltbar sind. Das Schalten des Moduls wird in Form eines sequentiellen Schaltens der einzelnen Untermodule durchgeführt, so dass das Modul z.B beim Abschalten abschnittsweise (d.h. Untermodul für Untermodul) heruntergefahren wird.

## Patentansprüche

1. Verfahren zur Vermeidung von Transienten bei Schaltvorgängen in integrierten Schaltkreisen,
mit den Schritten:
- Schalten eines Moduls (2.1, 2.2) von mehreren selektiv schaltbaren Modulen (2.1, 2.2) des integrierten Schaltkreises (1, 1') von einem ersten Betriebszustand in einen zweiten Betriebszustand, wobei eine Laständerung auftritt und der Übergang von dem ersten Betriebszustand in den zweiten Betriebszustand durch Ändern der Taktfrequenz des Moduls (2.1, 2.2) erzeugt wird, wobei ein gewünschter Zielwert für die Taktfrequenz des zu schaltenden Moduls variabel vorgebbar ist, indem eine Steuerschaltung (4) einen programmierbaren Frequenzteiler (3.2) anweist, die Taktfrequenz für das zu schaltende Modul (2.2) auf den gewünschten Zielwert zu reduzieren,
- gleichzeitiges Hinzuschalten einer Dummy-Last (2.3), welche die beim Schalten des Moduls (2.1, 2.2) auftretende Laständerung im wesentlichen kompensiert, wobei vor dem Hinzuschalten der Dummy-Last (2.3) die Höhe der Dummy-Last (2.3) in Abhängigkeit von dem zu schaltenden Modul und der beim Schaltvorgang auftretenden Laständerung eingestellt wird, und
- Steuern der Höhe der Dummy-Last (2.3) nach dem Hinzuschalten der Dummy-Last (2.3), so dass die Gesamtlast reduziert wird.

2. Verfahren nach Auspruch 1
**dadurch gekennzeichnet,**
**dass** die beiden Betriebszustände der eingeschaltete Zustand und der ausgeschaltete Zustand sind.

3. Verfahren nach Auspruch 1,
**dadurch gekennzeichnet,**
**dass** die beiden Betriebszustände der eingeschaltete Zustand und ein Zustand mit reduziertem Wert der Taktfrequenz des Moduls sind.

4. Integrierter Schaltkreis, welcher aufweist:
- mehrere selektiv zwischen einem ersten Betriebszustand und einem zweiten Betriebszustand schaltbare Module (2.1, 2.2), wobei ein Wechsel zwischen den Betriebszuständen mit einer Laständerung verbunden ist und durch Ändern der Taktfrequenz des Moduls erzeugt wird,
- eine zentrale Verarbeitungseinheit (2), die einen gewünschten Zielwert für die Taktfrequenz des zu schaltenden Moduls variabel bestimmt, indem eine mit der Verarbeitungseinheit (2) in Verbindung stehende Steuerschaltung (4) einen programmierbaren Frequenzteiler (3.2) anweist, die Taktfrequenz für das zu schaltende Modul (2.2) auf den gewünschten Zielwert zu reduzieren,
- Mittel zum Schalten des Moduls (2.1, 2.2) von dem ersten Betriebszustand in den zweiten Betriebszustand, und
- Mittel zum gleichzeitigen Hinzuschalten einer Dummy-Last (2.3), welche die beim Schalten des Moduls auftretende Laständerung im wesentlichen kompensiert, wobei die Höhe der Dummy-Last (2.3) vor dem Schaltvorgang in Abhängigkeit von dem zu schaltenden Modul und der beim Schaltvorgang auftretenden Laständerung einstellbar ist und die Höhe der Dummy-Last (2.3) nach dem Hinzuschalten der Dummy-Last (2.3) gesteuert wird, sodass die Gesamtlast reduziert wird.

5. Integrierter Schaltkreis nach Anspruch 4,
**dadurch gekennzeichnet,**
**dass** der integrierte Schaltkreis (1, 1') analoge und digitale Module umfasst.

6. Integrierter Schaltkreis nach einem der Ansprüche 4 oder 5
**dadurch gekennzeichnet,**
**dass** der integrierte Schaltkreis (1, 1') ein Chip einer Mobilstation eines Mobilfunksystems ist.

## Claims

1. Method for avoiding transients during switching processes in integrated circuits,
having the steps of:
- switching a module (2.1, 2.2) of a plurality of selectively switchable modules (2.1, 2.2) of the integrated circuit (1, 1') from a first operating state to a second operating state, a load change occurring and the transition from the first operating state to the second operating state being produced by changing the clock frequency of the module (2.1, 2.2), a desired target value for the clock frequency of the module to be switched being predeterminable in variable fashion, by virtue of the fact that a control circuit (4) instructs a programmable frequency divider (3.2) to reduce the clock frequency for the module (2.2) to be switched to the desired target value,
- simultaneously supplementarily connecting a dummy load (2.3), which essentially compensates for the load change occurring during the switching of the module (2.1, 2.2), the magnitude of the dummy load (2.3) being adjusted before the supplementary connection of the dummy load (2.3) in a manner dependent on the module to be switched and the load change occurring during the switching process, and
- controlling the magnitude of the dummy load (2.3) after the supplementary connection of the dummy load (2.3), so that the overall load is reduced.

2. Method according to Claim 1,
**characterized**
**in that** the two operating states are the switched-on state and the switched-off state.

3. Method according to Claim 1,
**characterized**
**in that** the two operating states are the switched-on state and a state with a reduced value of the clock frequency of the module.

4. Integrated circuit having:
- a plurality of modules (2.1, 2.2) that can be switched selectively between a first operating state and a second operating state, a change between the operating states being associated with a load change and being produced by changing the clock frequency of the module,
- a central processing unit (2), which determines in variable fashion a desired target value for the clock frequency of the module to be switched, by virtue of the fact that a control circuit (4), connected to the central processing unit (2), instructs a programmable frequency divider (3.2) to reduce the clock frequency for the module (2.2) to be switched to a desired target value,
- means for switching each module (2.1, 2.2) from the first operating state to the second operating state, and
- means for simultaneous supplementary connection of a dummy load (2.3), which essentially compensates for the load change occurring during the switching of the module, the magnitude of the dummy load (2.3) being adjustable before the switching process in a manner dependent on the module to be switched and the load change occurring during the switching process and the magnitude of the dummy load (2.3) being controlled after the supplementary connection of the dummy load (2.3), so that the overall load is reduced.

5. Integrated circuit according to Claim 4,
**characterized**
**in that** the integrated circuit (1, 1') comprises analog and digital modules.

6. Integrated circuit according to either of Claims 4 and 5,
**characterized**
**in that** the integrated circuit (1, 1') is a chip of a mobile station of a mobile radio system.

## Revendications

1. Procédé pour éviter des phénomènes transitoires lors d'opérations de commutation dans des circuits intégrés, comprenant les stades dans lesquels :
- on met en circuit un module (2.1, 2.2) parmi plusieurs modules (2.1, 2.2) pouvant être mis en circuit sélectivement du circuit (1, 1') intégré, en le faisant passer d'un premier état de fonctionnement à un deuxième état de fonctionnement, dans lequel une variation de charge se produit et le passage du premier état de fonctionnement au deuxième état de fonctionnement est produit par une modification de la fréquence d'horloge du module (2.1, 2.2), une valeur cible souhaitée de la fréquence d'horloge du module à mettre en circuit pouvant être prescrite de manière variable par le fait qu'un circuit (4) de commande donne instruction à un diviseur (3.2) de fréquence programmable de réduire la fréquence d'horloge du module (2.2) à mettre en circuit jusqu'à la valeur cible souhaitée,
- on met en circuit supplémentairement en même temps une charge (2.3) fictive, qui compense sensiblement la variation de charge se produisant lors de la mise en circuit du module (2.1, 2.2), dans lequel, avant la mise en circuit supplémentaire de la charge (2.3) fictive, on règle la valeur de la charge (2.3) fictive en fonction du module à mettre en circuit et de la variation de charge se produisant lors de l'opération de mise en circuit, et
- on règle la valeur de la charge (2.3) fictive, après la mise en circuit supplémentaire de la charge (2.3) fictive, de manière à réduire la charge globale.

2. Procédé suivant la revendication 1,
**caractérisé**
**en ce que** les deux états de fonctionnement sont l'état de mise en circuit et l'état de mise hors circuit.

3. Procédé suivant la revendication 1,
**caractérisé**
**en ce que** les deux états de fonctionnement sont l'état de mise en circuit et un état de valeur réduite de la fréquence d'horloge du module.

4. Circuit intégré, qui comprend :
- plusieurs modules (2.1, 2.2) pouvant être mis en circuit entre un premier état de fonctionnement et un deuxième état de fonctionnement, un passage entre les états de fonctionnement s'accompagnant d'une variation de charge et étant produit par variation de la fréquence d'horloge du module,
- une unité (2) centrale de traitement, qui détermine de manière variable une valeur cible souhaitée de la fréquence d'horloge du module à mettre en circuit par le fait qu'un circuit (4) de commande en liaison avec l'unité (2) de traitement donne instruction à un diviseur (3.2) de fréquence programmable de réduire la fréquence d'horloge du module (2.2) à mettre en circuit jusqu'à la valeur cible souhaitée,
- des moyens de mise en circuit du module (2.1, 2.2) en le faisant passer du premier état de fonctionnement au deuxième état de fonctionnement, et
- des moyens de mise en circuit supplémentairement en même temps d'une charge (2.3) fictive, qui compense sensiblement des variations de charge se produisant lors de la mise en circuit du module, la valeur de la charge (2.3) fictive pouvant être réglée avant l'opération de mise en circuit en fonction du module à mettre en circuit et de la variation de charge se produisant lors de l'opération de la mise en circuit et la valeur de la charge (2.3) fictive étant réglée, après la mise en circuit supplémentaire de la charge (2.3) fictive, de manière à réduire la charge globale.

5. Circuit intégré suivant la revendication 4,
**caractérisé**
**en ce que** le circuit (1, 1') intégré comprend des modules analogiques et numériques.

6. Circuit intégré suivant l'une des revendications 4 ou 5,
**caractérisé**
**en ce que** le circuit (1, 1') intégré est une puce d'une station mobile d'un système de téléphonie mobile.
